# EUROPEAN PATENT APPLICATION

(11) **EP 4 654 756 A1**
(43) Date of publication of application: **26.11.2025**
(21) Application number: 24744744.4
(22) Date of filing: 19.01.2024
(51) Int. Cl.: H05H 1/46, F04D 19/04, F04D 29/64

(54) **EVACUATION DEVICE AND PLASMA GENERATOR**

(30) Priority: 20.01.2023 JP 2023007355
(71) Applicant: Edwards Japan Limited, Yachiyo-shi, Chiba 276-8523 (JP)
(72) Inventor: KABASAWA, Takashi, Yachiyo-shi Chiba 276-8523 (JP)
(74) Representative: Openshaw & Co.
(86) International application number: PCT/JP2024/001463
(87) International publication number: WO 2024/154824

(57) **Abstract**

A vacuum exhaust apparatus that enables downsizing is provided. The vacuum exhaust apparatus includes a turbomolecular pump and a plasma generator 210. The plasma generator 210 includes a displaceable electrode 214 and is capable of sealing a plasma communication port 228 by displacing the electrode 214 during non-operation in which plasma is not generated. Supply piping for source gas for generating plasma is connected to the plasma generator 210, and the source gas is used to displace the electrode 214. The plasma generator 210 includes a piston 220 and the electrode 214 is displaced by a pressure difference acting on the piston 220.

## Description

The present invention relates to a vacuum exhaust apparatus including a vacuum pump, such as a turbomolecular pump, and a plasma generator that can be combined with a vacuum pump.

A turbomolecular pump is commonly known as one type of vacuum pump. The turbomolecular pump may be used for exhaustion of a manufacturing apparatus for semiconductors or flat panels, for example. In a turbomolecular pump, a motor in a pump main body is energized to rotate rotor blades, thereby hitting gaseous molecules (gas molecules) of the gas (process gas) drawn into a pump main body, and exhausting the gas. Some types of such turbomolecular pumps have heaters and cooling pipes to appropriately manage the temperature inside the pumps.

In a vacuum pump such as a turbomolecular pump, reaction products generated in a manufacturing process of semiconductors and the like may accumulate in a vacuum pump. PTL 1 discloses a technique for cleaning the inside of a vacuum pump with plasma by installing a plasma generator in the vacuum pump so as to be a countermeasure against reaction products.

[PTL 1] Japanese Patent Application Publication No. 2022-017864

In the invention disclosed in PLT 1, a plasma source is installed via a valve at an introduction port disposed in a side surface of the vacuum pump. This may increase the overall projecting dimension of the vacuum exhaust apparatus, in which the vacuum pump and the plasma generator are combined.

At the same time, an actuator for a conductance valve connected to an inlet port of the vacuum pump, various piping, frames, and the like may be placed around the vacuum pump. In this case, there may not be enough space around the vacuum pump to install a plasma generator. In some cases, installing a plasma generator needs extensive modifications of the vacuum pump or surroundings thereof.

It is an object of the present invention to provide a vacuum exhaust apparatus and a plasma generator that enable downsizing.
(1) A vacuum exhaust apparatus according to the present invention for achieving the above object is
   a vacuum exhaust apparatus including a vacuum pump and a plasma generator, wherein
   the plasma generator includes a displaceable electrode and is capable of sealing a plasma communication port by displacing the electrode during non-operation in which plasma is not generated.
(2) A plasma generator according to the present invention for achieving the above object includes
   a displaceable electrode for plasma generation and for sealing a plasma communication port.

According to the above invention, it is possible to provide a vacuum exhaust apparatus and a plasma generator that enable downsizing.

[Fig. 1]

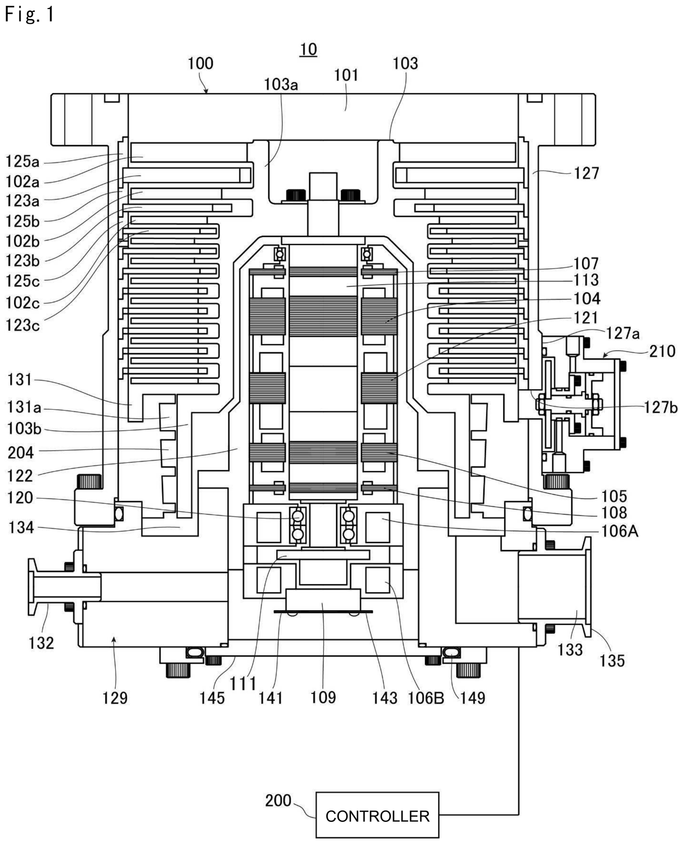

   Fig. 1 is an explanatory diagram schematically showing a configuration of a vacuum exhaust apparatus according to a first embodiment of the present invention.
[Fig. 2]

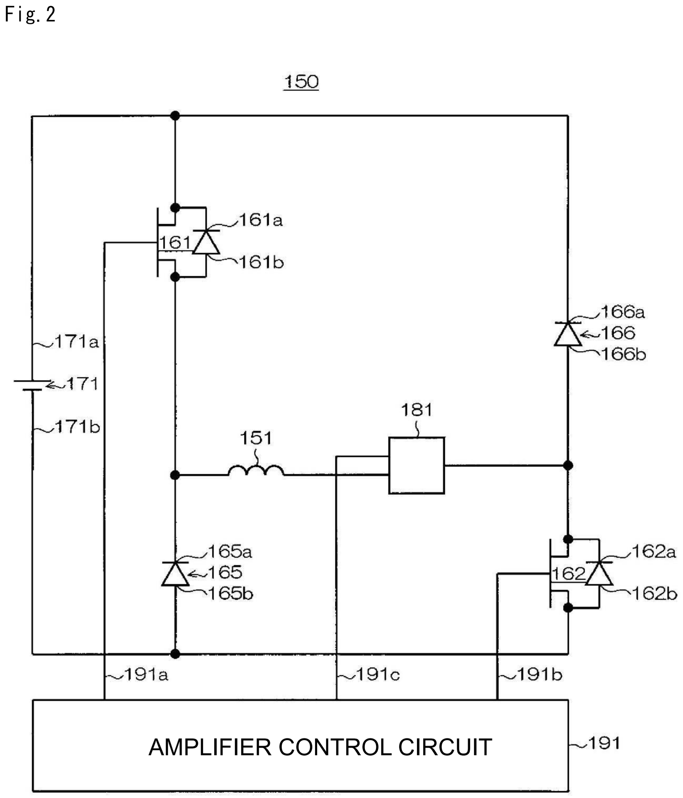

   Fig. 2 is a circuit diagram of an amplifier circuit.
[Fig. 3]

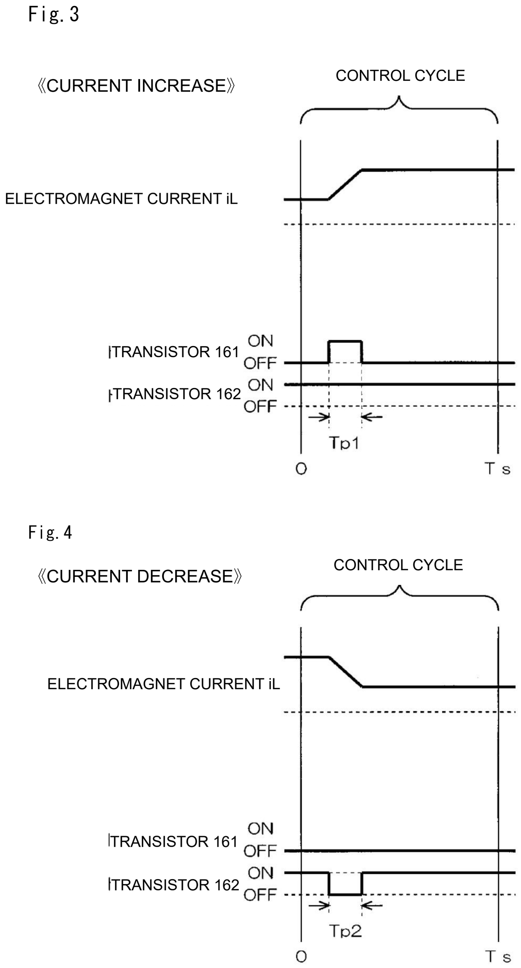

   Fig. 3 is a time chart showing control performed when a current command value is greater than a detected value.
[Fig. 4]
   Fig. 4 is a time chart showing control performed when a current command value is less than a detected value.
[Fig. 5]

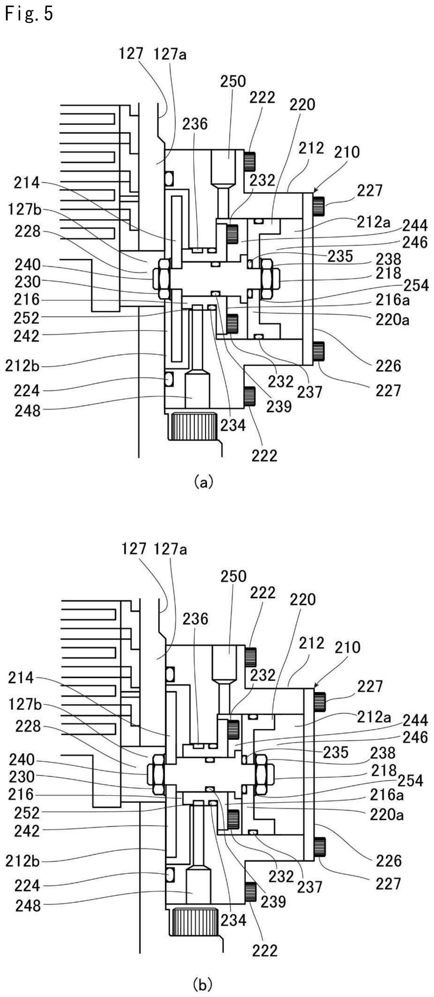

   Fig. 5 is an enlarged explanatory diagram showing a plasma generator according to the first embodiment and its surrounding portion.
[Fig. 6]

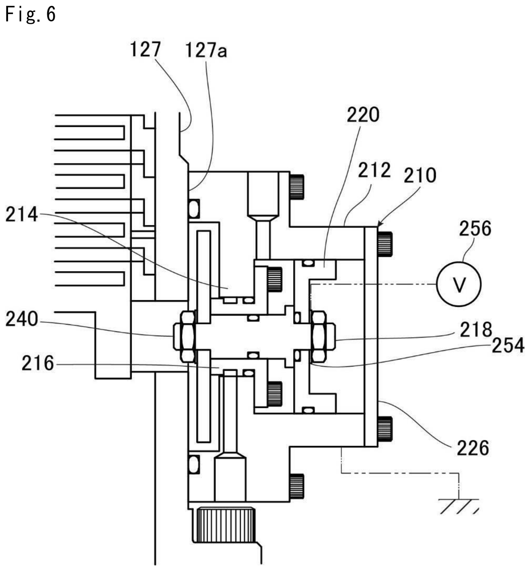

   Fig. 6 is an explanatory diagram schematically showing a flow of power supply to the plasma generator.
[Fig. 7]

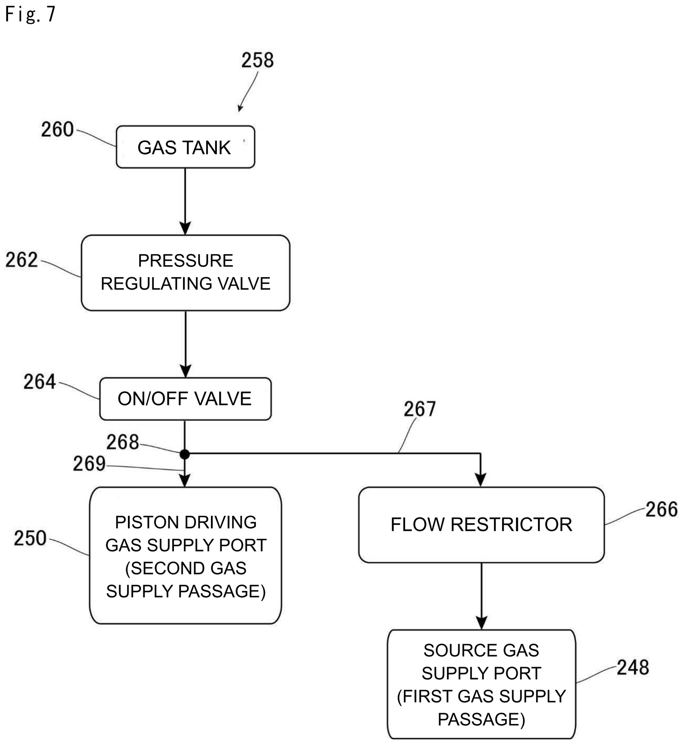

   Fig. 7 is a block diagram schematically showing a source gas supply line.
[Fig. 8]

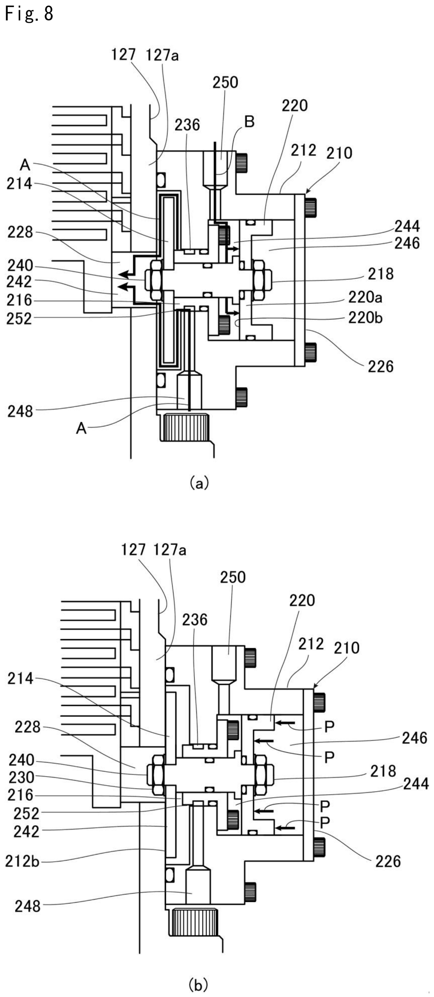

   Fig. 8(a) is an explanatory diagram showing a state of the plasma generator during operation of the turbomolecular pump, and Fig. 8(b) is an explanatory diagram showing a state of the plasma generator during standby of the turbomolecular pump.
[Fig. 9]

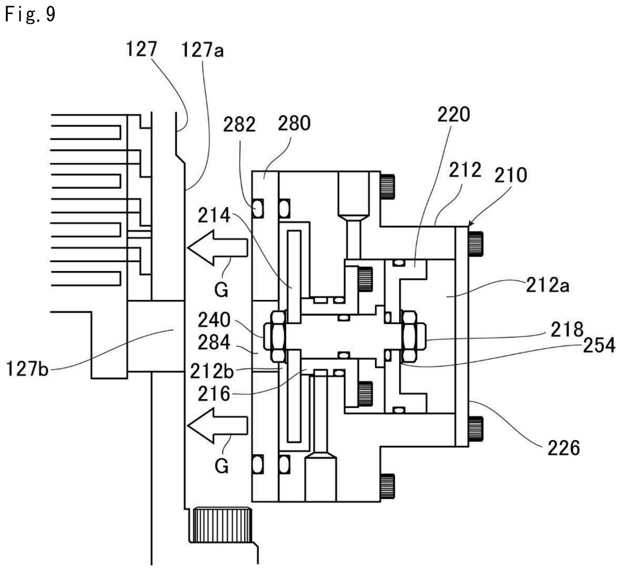

   Fig. 9 is an explanatory diagram showing a modification including a coupling plate.
[Fig. 10]

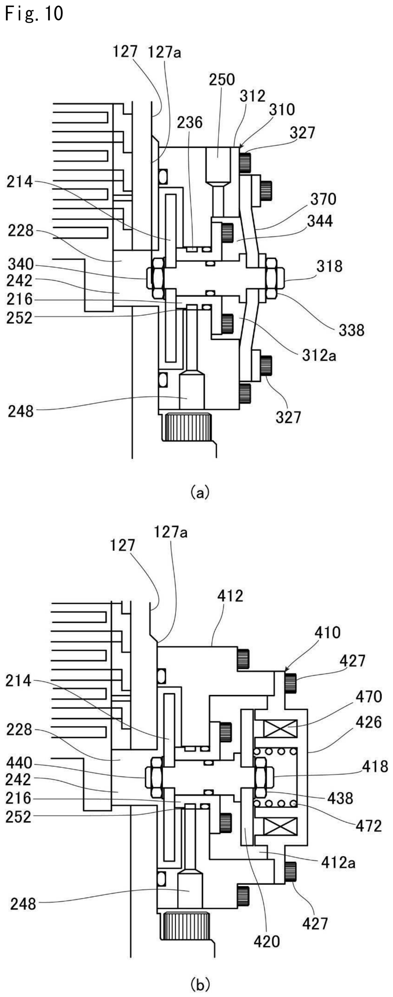

   Fig. 10(a) is an enlarged explanatory diagram showing a plasma generator according to a second embodiment of the present invention and its surrounding portion, and Fig. 10(b) is an enlarged explanatory diagram showing a plasma generator according to a third embodiment of the present invention and its surrounding portion.

### <Basic Configuration of Vacuum Exhaust Apparatus 10 of First Embodiment>

Fig. 1 shows a vacuum exhaust apparatus 10 according to a first embodiment of the present invention. The vacuum exhaust apparatus 10 includes a turbomolecular pump 100 as a vacuum pump and a plasma generator 210. Although the details will be described below, the turbomolecular pump 100 performs vacuum exhaustion, and the plasma generator 210 performs plasma cleaning of the reaction products generated in the turbomolecular pump 100.

More specifically, the vacuum exhaust apparatus 10 has at least three operation modes (operation modes 1 to 3). Operation mode 1 is a normal operation mode. During normal operation in the normal operation mode, the turbomolecular pump 100 is operated at the rated speed, and the plasma generator 210 is in a plasma cleaning OFF state (cleaning OFF state).

Operation mode 2 is a cleaning mode. During cleaning in the cleaning mode, the turbomolecular pump 100 is in a low-speed operation state or a stopped (operation stop) state. The plasma generator 210 is in a plasma cleaning ON state (cleaning ON state).

Operation mode 3 is a standby mode. During standby in the standby mode, the turbomolecular pump 100 is in a low-speed operation or stopped (operation stop) state, as in operation mode 2. The plasma generator 210 is in the plasma cleaning OFF state (cleaning OFF state) as in operation mode 1.

In this embodiment, the term "during non-operation" may be used. Regarding the vacuum exhaust apparatus 10, a state in which plasma is not generated is defined as "during non-operation". Operation mode 1 and operation mode 3 described above are included in "during non-operation". In contrast, a state in which plasma is generated may be referred to as "during operation". Operation mode 2 described above is included in "during operation". The operation of the plasma generator 210 in each operation mode (particularly during cleaning and during standby) will be described below.

### <Turbomolecular Pump 100>

Fig. 1 shows the turbomolecular pump 100 as a vacuum pump according to the first embodiment of the present invention. The turbomolecular pump 100 is to be connected to a vacuum chamber (not shown) of a target apparatus such as a semiconductor manufacturing apparatus.

Fig. 1 is a vertical cross-sectional view of the turbomolecular pump 100. As shown in Fig. 1, the turbomolecular pump 100 has a circular outer cylinder 127 having an inlet port 101 at its upper end. A rotating body 103 in the outer cylinder 127 includes a plurality of rotor blades 102 (102a, 102b, 102c, ...), which are turbine blades for gas suction and exhaustion, in its outer circumference section. The rotor blades 102 extend radially in multiple stages. The rotating body 103 has a rotor shaft 113 in its center. The rotor shaft 113 is supported and suspended in the air and position-controlled by a magnetic bearing of 5-axis control, for example.

Upper radial electromagnets 104 include four electromagnets arranged in pairs on an X-axis and a Y-axis. Four upper radial sensors 107 are provided in close proximity to the upper radial electromagnets 104 and associated with the respective upper radial electromagnets 104. Each upper radial sensor 107 may be an inductance sensor or an eddy current sensor having a conduction winding, for example, and detects the position of the rotor shaft 113 based on a change in the inductance of the conduction winding, which changes according to the position of the rotor shaft 113. The upper radial sensors 107 are configured to detect a radial displacement of the rotor shaft 113, that is, the rotating body 103 fixed to the rotor shaft 113, and send it to the controller 200.

In the controller 200, for example, a compensation circuit having a PID adjustment function generates an excitation control command signal for the upper radial electromagnets 104 based on a position signal detected by the upper radial sensors 107. Based on this excitation control command signal, an amplifier circuit 150 (described below) shown in Fig. 2 controls and excites the upper radial electromagnets 104 to adjust a radial position of an upper part of the rotor shaft 113.

The rotor shaft 113 may be made of a high magnetic permeability material (such as iron and stainless steel) and is configured to be attracted by magnetic forces of the upper radial electromagnets 104. The adjustment is performed independently in the X-axis direction and the Y-axis direction. Lower radial electromagnets 105 and lower radial sensors 108 are arranged in a similar manner as the upper radial electromagnets 104 and the upper radial sensors 107 to adjust the radial position of the lower part of the rotor shaft 113 in a similar manner as the radial position of the upper part.

Additionally, axial electromagnets 106A and 106B are arranged so as to vertically sandwich a metal disc 111 (also referred to as an "armature disc"), which has the shape of a circular disc and is provided in the lower part of the rotor shaft 113. The metal disc 111 is made of a high magnetic permeability material such as iron. An axial sensor 109 is provided to detect an axial displacement of the rotor shaft 113 and send an axial position signal to the controller 200.

In the controller 200, the compensation circuit having the PID adjustment function may generate an excitation control command signal for each of the axial electromagnets 106A and 106B based on the signal on the axial position detected by the axial sensor 109. Based on these excitation control command signals, the amplifier circuit 150 controls and excites the axial electromagnets 106A and 106B separately so that the axial electromagnet 106A magnetically attracts the metal disc 111 upward and the axial electromagnet 106B attracts the metal disc 111 downward. The axial position of the rotor shaft 113 is thus adjusted.

As described above, the controller 200 appropriately adjusts the magnetic forces exerted by the axial electromagnets 106A and 106B on the metal disc 111, magnetically levitates the rotor shaft 113 in the axial direction, and suspends the rotor shaft 113 in the air in a non-contact manner. The amplifier circuit 150, which controls and excites the upper radial electromagnets 104, the lower radial electromagnets 105, and the axial electromagnets 106A and 106B, is described below.

The motor 121 includes a plurality of magnetic poles circumferentially arranged to surround the rotor shaft 113. Each magnetic pole is controlled by the controller 200 so as to drive and rotate the rotor shaft 113 via an electromagnetic force acting between the magnetic pole and the rotor shaft 113. The motor 121 also includes a rotational speed sensor (not shown), such as a Hall element, a resolver, or an encoder, and the rotational speed of the rotor shaft 113 is detected based on a detection signal of the rotational speed sensor.

Furthermore, a phase sensor (not shown) is attached adjacent to the lower radial sensors 108 to detect the phase of rotation of the rotor shaft 113. The controller 200 detects the position of the magnetic poles using both detection signals of the phase sensor and the rotational speed sensor.

A plurality of stator blades 123 (123a, 123b, 123c, ...) are arranged slightly spaced apart (by predetermined gaps) from the rotor blades 102 (102a, 102b, 102c). Each rotor blade 102 (102a, 102b, 102c, ...) is inclined by a predetermined angle from a plane perpendicular to the axis of the rotor shaft 113 in order to transfer exhaust gas molecules downward through collision.

The stator blades 123 are also inclined by a predetermined angle from a plane perpendicular to the axis of the rotor shaft 113. The stator blades 123 extend inward of the outer cylinder 127 and alternate with the stages of the rotor blades 102. The outer circumference ends of the stator blades 123 are inserted between and thus supported by a plurality of layered stator blade spacers 125 (125a, 125b, 125c, ...).

The stator blade spacers 125 are ring-shaped members made of a metal, such as aluminum, iron, stainless steel, or copper, or an alloy containing these metals as components, for example. The outer cylinder 127 is fixed to the outer circumferences of the stator blade spacers 125 with a slight gap. A base portion 129 is located at the base of the outer cylinder 127. The base portion 129 has an outlet port 133 providing communication to the outside. The exhaust gas transferred to the base portion 129 through the inlet port 101 from the chamber (vacuum chamber) is then sent to the outlet port 133.

According to the application of the turbomolecular pump 100, a threaded spacer 131 may be provided between the lower part of the stator blade spacer 125 and the base portion 129. The threaded spacer 131 is a cylindrical member made of a metal such as aluminum, copper, stainless steel, or iron, or an alloy containing these metals as components. The threaded spacer 131 has a plurality of helical thread grooves 131a in its inner circumference surface. When exhaust gas molecules move in the rotation direction of the rotating body 103, these molecules are transferred toward the outlet port 133 in the direction of the helix of the thread grooves 131a. A rotating body lower cylindrical portion 103b extends downward from the lower part of a rotating body main portion 103a of the rotating body 103 including the rotor blades 102 (102a, 102b, 102c, ...). The outer circumference surface of the rotating body lower cylindrical portion 103b is cylindrical and projects toward the inner circumference surface of the threaded spacer 131. The outer circumference surface is adjacent to but separated from the inner circumference surface of the threaded spacer 131 by a predetermined gap. The exhaust gas transferred to the thread groove 131a by the rotor blades 102 and the stator blades 123 is guided by the thread groove 131a to the base portion 129. Thus, the threaded spacer 131 and the opposed rotating body lower cylindrical portion 103b form a Holweck type exhaust mechanism portion 204. The Holweck type exhaust mechanism portion 204 gives directivity to the exhaust gas by rotating the rotating body lower cylindrical portion 103b relative to the threaded spacer 131, thereby improving the exhaust characteristics of the turbomolecular pump 100.

The base portion 129 is a disc-shaped member forming the base section of the turbomolecular pump 100, and is generally made of a metal such as iron, aluminum, or stainless steel. The base portion 129 physically holds the turbomolecular pump 100 and also serves as a heat conduction path. As such, the base portion 129 is preferably made of rigid metal with high thermal conductivity, such as iron, aluminum, or copper.

In this configuration, when the motor 121 drives and rotates the rotor blades 102 together with the rotor shaft 113, the interaction between the rotor blades 102 and the stator blades 123 causes the suction of exhaust gas from the chamber through the inlet port 101. The exhaust gas taken through the inlet port 101 moves between the rotor blades 102 and the stator blades 123 and is transferred to the base portion 129. At this time, factors such as the friction heat generated when the exhaust gas comes into contact with the rotor blades 102 and the conduction of heat generated by the motor 121 increase the temperature of the rotor blades 102. This heat is conducted to the stator blades 123 through radiation or conduction via gaseous molecules (gas molecules) of the exhaust gas, for example.

The stator blade spacers 125 are joined to each other at the outer circumference portion and conduct the heat received by the stator blades 123 from the rotor blades 102, the friction heat generated when the exhaust gas comes into contact with the stator blades 123, and the like to the outside.

In the above description, the threaded spacer 131 is provided at the outer circumference of the rotating body lower cylindrical portion 103b of the rotating body 103, and the thread groove 131a is engraved in the inner circumference surface of the threaded spacer 131. However, this may be inversed in some cases, and a thread groove may be engraved in the outer circumference surface of the rotating body lower cylindrical portion 103b, while a spacer having a cylindrical inner circumference surface may be arranged around the outer circumference surface.

According to the application of the turbomolecular pump 100, to prevent the gas drawn through the inlet port 101 from entering an electrical portion, which includes the upper radial electromagnets 104, the upper radial sensors 107, the motor 121, the lower radial electromagnets 105, the lower radial sensors 108, the axial electromagnets 106A, 106B, and the axial sensor 109, the electrical portion may be surrounded by a stator column 122. The inside of the stator column 122 may be maintained at a predetermined pressure by purge gas.

In this case, the base portion 129 has a purge gas port 132 through which the purge gas is introduced. The introduced purge gas is sent to the outlet port 133 through a gap between a protective bearing 120 and the rotor shaft 113, a gap between the rotor and the stator of the motor 121, and a gap 134 between the inner cylindrical portion of the rotor blades 102 (the rotating body lower cylindrical portion 103b) and the stator column 122 and the base portion 129.

The turbomolecular pump 100 requires the identification of the model and control based on individually adjusted unique parameters (for example, various characteristics associated with the model). To store these control parameters, the turbomolecular pump 100 includes an electronic circuit portion 141 in its main body. The electronic circuit portion 141 may include a semiconductor memory, such as an EEPROM, electronic components such as semiconductor elements for accessing the semiconductor memory, and a substrate 143 for mounting these components. The electronic circuit portion 141 is housed under a rotational speed sensor (not shown) near the center, for example, of the base portion 129, which forms the lower part of the turbomolecular pump 100, and is closed by an airtight bottom lid 145.

Some process gas introduced into the chamber in the manufacturing process of semiconductors has the property of becoming solid when its pressure becomes higher than a predetermined value or its temperature becomes lower than a predetermined value. In the turbomolecular pump 100, the pressure of the exhaust gas is lowest at the inlet port 101 and highest at the outlet port 133. When the pressure of the process gas increases beyond a predetermined value or its temperature decreases below a predetermined value while the process gas is being transferred from the inlet port 101 to the outlet port 133, the process gas is solidified and adheres and accumulates on the inner side of the turbomolecular pump 100.

For example, when SiCl₄ is used as the process gas in an Al etching apparatus, according to the vapor pressure curve, a solid product (for example, AlCl3) is deposited at a low vacuum (760 [torr] to 10-2 [torr]) and a low temperature (about 20 [°C]) and adheres and accumulates on the inner side of the turbomolecular pump 100. When the deposit of the process gas accumulates in the turbomolecular pump 100, the accumulation may narrow the pump flow passage and degrade the performance of the turbomolecular pump 100. The above-mentioned product tends to solidify and adhere in areas with higher pressures, such as the vicinity of the outlet port 133 and the vicinity of the threaded spacer 131.

To solve this problem, conventionally, a heater or annular water-cooled tube 149 (not shown) is wound around the outer circumference of the base portion 129, and a temperature sensor (e.g., a thermistor, not shown) is embedded in the base portion 129, for example. The signal of this temperature sensor is used to perform control to maintain the temperature of the base portion 129 at a constant high temperature (preset temperature) by heating with the heater or cooling with the water-cooled tube 149 (hereinafter referred to as TMS (temperature management system)). In the present embodiment, a heater (not shown) embedded in the threaded spacer 131 heats the threaded spacer 131, and the water-cooled tube 149 embedded in the bottom lid 145 cools the base portion 129.

The amplifier circuit 150 is now described that controls and excites the upper radial electromagnets 104, the lower radial electromagnets 105, and the axial electromagnets 106A and 106B of the turbomolecular pump 100 configured as described above. Fig. 2 is a circuit diagram of the amplifier circuit.

In Fig. 2, one end of an electromagnet winding 151 forming an upper radial electromagnet 104 or the like is connected to a positive electrode 171a of a power supply 171 via a transistor 161, and the other end is connected to a negative electrode 171b of the power supply 171 via a current detection circuit 181 and a transistor 162. Each transistor 161, 162 is a power MOSFET and has a structure in which a diode is connected between the source and the drain thereof.

In the transistor 161, a cathode terminal 161a of its diode is connected to the positive electrode 171a, and an anode terminal 161b is connected to one end of the electromagnet winding 151. In the transistor 162, a cathode terminal 162a of its diode is connected to a current detection circuit 181, and an anode terminal 162b is connected to the negative electrode 171b.

A diode 165 for current regeneration has a cathode terminal 165a connected to one end of the electromagnet winding 151 and an anode terminal 165b connected to the negative electrode 171b. Similarly, a diode 166 for current regeneration has a cathode terminal 166a connected to the positive electrode 171a and an anode terminal 166b connected to the other end of the electromagnet winding 151 via the current detection circuit 181. The current detection circuit 181 may include a Hall current sensor or an electric resistance element, for example.

The amplifier circuit 150 configured as described above corresponds to one electromagnet. Accordingly, when the magnetic bearing uses 5-axis control and has ten electromagnets 104, 105, 106A, and 106B in total, an identical amplifier circuit 150 is configured for each of the electromagnets. These ten amplifier circuits 150 are connected to the power supply 171 in parallel.

An amplifier control circuit 191 may be formed by a digital signal processor portion (not shown, hereinafter referred to as a DSP portion) of the controller 200. The amplifier control circuit 191 switches the transistors 161 and 162 between on and off.

The amplifier control circuit 191 is configured to compare a current value detected by the current detection circuit 181 (a signal reflecting this current value is referred to as a current detection signal 191c) with a predetermined current command value. The result of this comparison is used to determine the magnitude of the pulse width (pulse width time Tp1, Tp2) generated in a control cycle Ts, which is one cycle in PWM control. As a result, gate drive signals 191a and 191b having this pulse width are output from the amplifier control circuit 191 to gate terminals of the transistors 161 and 162.

Under certain circumstances such as when the rotational speed of the rotating body 103 reaches a resonance point during acceleration, or when a disturbance occurs during a constant speed operation, the rotating body 103 may require positional control at high speed and with a strong force. For this purpose, a high voltage of about 50 V, for example, is used for the power supply 171 to enable a rapid increase (or decrease) in the current flowing through the electromagnet winding 151. Additionally, a capacitor is generally connected between the positive electrode 171a and the negative electrode 171b of the power supply 171 to stabilize the power supply 171 (not shown).

In this configuration, when both transistors 161 and 162 are turned on, the current flowing through the electromagnet winding 151 (hereinafter referred to as an electromagnet current iL) increases, and when both are turned off, the electromagnet current iL decreases.

Also, when one of the transistors 161 and 162 is turned on and the other is turned off, a freewheeling current is maintained. Passing the freewheeling current through the amplifier circuit 150 in this manner reduces the hysteresis loss in the amplifier circuit 150, thereby limiting the power consumption of the entire circuit to a low level. Moreover, by controlling the transistors 161 and 162 as described above, high frequency noise, such as harmonics, generated in the turbomolecular pump 100 can be reduced. Furthermore, by measuring this freewheeling current with the current detection circuit 181, the electromagnet current iL flowing through the electromagnet winding 151 can be detected.

That is, when the detected current value is smaller than the current command value, as shown in Fig. 3, the transistors 161 and 162 are simultaneously on only once in the control cycle Ts (for example, 100 µs) for the time corresponding to the pulse width time Tp1. During this time, the electromagnet current iL increases accordingly toward the current value iLmax (not shown) that can be passed from the positive electrode 171a to the negative electrode 171b via the transistors 161 and 162.

When the detected current value is larger than the current command value, as shown in Fig. 4, the transistors 161 and 162 are simultaneously off only once in the control cycle Ts for the time corresponding to the pulse width time Tp2. During this time, the electromagnet current iL decreases accordingly toward the current value iLmin (not shown) that can be regenerated from the negative electrode 171b to the positive electrode 171a via the diodes 165 and 166.

In either case, after the pulse width time Tp1, Tp2 has elapsed, one of the transistors 161 and 162 is on. During this period, the freewheeling current is thus maintained in the amplifier circuit 150.

In the turbomolecular pump 100 with the basic configuration described above, the upper side as viewed in Fig. 1 (the side including the inlet port 101) serves as a suction portion connected to the target apparatus, and the lower side (the side including the base portion 129 at which the outlet port 133 connecting to the exhaust port 135 protrudes rightward as viewed in the figure) serves as an exhaust portion connected to an auxiliary pump (back pump) or the like (not shown). The turbomolecular pump 100 can be used not only in an upright position in the vertical direction shown in Fig. 1, but also in an inverted position, a horizontal position, and an inclined position.

Also, in the turbomolecular pump 100, the above-mentioned outer cylinder 127 and the base portion 129 are combined to form a single case (hereinafter, they may be collectively referred to as a "main body casing" or the like). The turbomolecular pump 100 is electrically (and structurally) connected to a box-shaped electrical case (not shown), and the above-mentioned controller 200 is incorporated in the electrical case.

The configuration within the main body casing (the combination of the outer cylinder 127 and the base portion 129) of the turbomolecular pump 100 may be divided into a rotation mechanism portion, which rotates the rotor shaft 113 and the like with the motor 121, and an exhaust mechanism portion, which is rotationally driven by the rotation mechanism portion. The exhaust mechanism portion may be divided into a turbomolecular pump mechanism portion, which may include the rotor blades 102, the stator blades 123, and the like, and a thread groove pump mechanism portion (Holweck type exhaust mechanism portion), which may include the rotating body lower cylindrical portion 103b, the threaded spacer 131, and the like.

The above-mentioned purge gas (protection gas) is used to protect components such as the bearing portions and the rotor blades 102, prevents corrosion caused by the exhaust gas (process gas), and cools the rotor blades 102, for example. This purge gas may be supplied by a general technique.

For example, the above-mentioned purge gas port 132 extending linearly in the radial direction may be provided at a predetermined part of the base portion 129 (for example, at a position approximately 90 or 120 degrees away from the outlet port 133). The purge gas may be supplied to the purge gas port 132 from the outside of the base portion 129 via a purge gas cylinder (e.g., N2 gas cylinder), a flow rate regulator (valve device), or the like.

The protective bearing 120 described above is also referred to as a "touchdown (T/D) bearing", a "backup bearing", or the like. In case of any trouble such as trouble in the electrical system or entry of air, the protective bearing 120 prevents a significant change in the position and orientation of the rotor shaft 113, thereby limiting damage to the rotor blades 102 and surrounding portions.

In Fig. 1 showing the structure of the turbomolecular pump 100 and the rotating body 103, hatch patterns indicating cross sections of components are omitted to avoid complicating the drawing.

### <Basic Configuration of Plasma Generator 210>

As described above, products may accumulate inside the turbomolecular pump 100. In the present embodiment, a plasma generator 210 as shown in Fig. 5(a) is used to clear the products.

The plasma generator 210 includes an electrode 214, an insulation spacer 216, a movable shaft 218, a piston 220, and the like inside a cylinder 212. The cylinder 212 may be formed by processing a metal, such as aluminum or stainless steel, into a cylindrical shape having steps at its outer and inner circumferences.

The cylinder 212 is fixed to a seating surface 127a of the outer cylinder 127 of the turbomolecular pump 100 with a plurality of (for example, six) hexagon socket head cap screws 222. The seating surface 127a includes a flat surface. An O-ring 224 hermetically seals between the cylinder 212 and the outer cylinder 127. The cylinder 212 is fixed to the seating surface 127a of the outer cylinder 127 in a state in which heat can be transferred between the cylinder 212 and the outer cylinder 127.

Openings 212a and 212b are formed at opposite ends of the cylinder 212 in the axial direction (horizontal direction in Fig. 5(a)). A lid 226 closes the opening 212a on one side (the right side in Fig. 5(a)). The lid 226 is fixed to the cylinder 212 with a plurality of (for example, six) hexagon socket head cap screws 227.

The other opening 212b (on the left side in Fig. 5(a)) is spatially connected to an opening 127b formed in the outer cylinder 127 of the turbomolecular pump 100. The opening 212b of the cylinder 212 and the opening 127b of the outer cylinder 127 form a plasma communication port 228 through which plasma is introduced from the plasma generator 210 to the turbomolecular pump 100.

In the present embodiment, the plasma communication port 228 opens facing the boundary between the turbomolecular pump mechanism portion, which may include the rotor blades 102, the stator blades 123, and the like, and the thread groove pump mechanism portion (Holweck type exhaust mechanism portion 204), which may include the rotating body lower cylindrical portion 103b, the threaded spacer 131, and the like.

The electrode 214 located within the cylinder 212 is disc-shaped. The electrode 214 is concentrically fixed to the front end of the movable shaft 218 (the end on the left side in Fig. 5(a), the end on the side corresponding to the turbomolecular pump 100) with a hexagonal nut 230. As the material of the electrode 214, various known materials such as materials for plasma electrodes can be used.

The movable shaft 218 has the shape of a column with steps and is inserted in the cylindrical insulation spacer 216. A middle section of the movable shaft 218 in the axial direction is inserted within the insulation spacer 216. For example, as a material for the movable shaft 218, a metal such as aluminum or stainless steel may be used.

The insulation spacer 216 is processed into a cylindrical shape having a flange portion 216a. The insulation spacer 216 is positioned within the cylinder 212 and concentric with the cylinder 212. As a material for the insulation spacer 216, a material having electrical insulating properties (such as an insulating resin) may be used.

Hexagon socket head cap screws 232 are inserted in the flange portion 216a of the insulation spacer 216. The hexagon socket head cap screws 232 are threaded in the cylinder 212. The insulation spacer 216 is fixed to the cylinder 212 with the hexagon socket head cap screws 232. An O-ring 234 hermetically seals between the insulation spacer 216 and the cylinder 212.

The outer circumference surface of the insulation spacer 216 has a source gas introduction groove 236 extending over the entire circumference. The source gas introduction groove 236 is used to allow the source gas for generating plasma to flow, and the configuration for displacing the electrode 214 will be described below.

The piston 220 is concentrically fixed with a hexagonal nut 238 to the rear end of the movable shaft 218 (the end on the right side in Fig. 5(a), the end on the side opposite to the turbomolecular pump 100). The piston 220 is cylindrical and has a head portion 220a. As a material for the piston 220, a material having electrical insulating properties (such as an insulating resin) may be used. The function of the piston 220 will be described below.

An O-ring 235 hermetically seals between the piston 220 and the movable shaft 218. An O-ring 237 hermetically seals between the piston 220 and the cylinder 212. An O-ring 239 hermetically seals between the movable shaft 218 and the insulation spacer 216.

The electrode 214, the movable shaft 218, and the piston 220 are integrated to form a movable body 240 having conductivity. The movable body 240 can be displaced in the axial directions to advance and retract while being supported by the insulation spacer 216. The movable body 240 is displaced relative to insulation spacer 216 (and the cylinder 212).

Fig. 5(a) shows a state in which the movable body 240 is retracted (displaced to the right in Fig. 5(a)) and the electrode 214 interferes with the insulation spacer 216. In this state, the electrode 214 is spaced apart from the seating surface 127a of the outer cylinder 127. In contrast, in Fig. 5(b), the movable body 240 is advanced (displaced to the left in Fig. 5(b)), and the electrode 214 interferes with the seating surface 127a of the outer cylinder 127 and seals the plasma communication port 228.

The above displacement of the movable shaft 218 and the electrode 214 is controlled by the difference in internal pressure between a first chamber 242, a second chamber 244, and a third chamber 246 formed within the cylinder 212. As shown in Figs. 5(a) and 5(b), the first chamber 242 is a space in which the electrode 214 is placed. The second chamber 244 is a space defined by the flange portion 216a of the insulation spacer 216 and the head portion 220a of the piston 220. The third chamber 246 is a space defined by the piston 220 and the lid 226.

The cylinder 212 includes one first gas supply passage 248 and one second gas supply passage 250. The first gas supply passage 248 and the second gas supply passage 250 are passages having circular cross-sections and extending in radial directions of the cylinder 212.

The first gas supply passage 248 opens facing the source gas introduction groove 236 formed in the outer circumference surface of the insulation spacer 216 and is spatially connected to the source gas introduction groove 236. A section between the source gas introduction groove 236 and the first chamber 242 is not hermetically sealed, and the source gas introduction groove 236 and the first chamber 242 are spatially connected. In this embodiment, the section between the source gas introduction groove 236 and the first chamber 242 is a narrowed portion 252, which extends over the entire circumference of the insulation spacer 216 and narrows the flow path.

The second gas supply passage 250 opens facing the second chamber 244. The second gas supply passage 250 and the second chamber 244 are spatially connected.

As shown in Fig. 5(a), an annular crimp terminal 254 is sandwiched between the hexagonal nut 238, which fixes the piston 220 to the movable shaft 218, and the piston 220. The crimp terminal 254 is electrically connected to the electrode 214 through the movable shaft 218. Also, the crimp terminal 254 is connected to a power supply 256 as schematically shown in Fig. 6, and the power supply 256 applies a high voltage to the electrode 214 to generate plasma. In this embodiment, the cylinder 212 is grounded.

### <Structure for Displacing Electrode 214>

Source gas is supplied to the first gas supply passage 248 and the second gas supply passage 250. The source gas may be gases such as NF3 (nitrogen trifluoride) and CF4 (tetrafluoromethane), for example. The gas is not limited to the above, and, instead of source gas, other gases (such as air) may be used to displace the movable body 240.

Fig. 7 schematically shows a supply line 258 of the source gas supplied to the first gas supply passage 248 and the second gas supply passage 250. The supply line 258 includes a gas tank 260, a pressure regulating valve 262, an ON/OFF valve 264, a flow restrictor 266, supply piping 267 and 269 (indicated by arrows), and the like.

The gas tank 260 supplies source gas at a predetermined pressure (for example, 10 [MPa]) toward the plasma generator 210. The pressure regulating valve 262 reduces the pressure of the source gas. The pressure regulating valve 262 may reduce the pressure of the source gas from 10 [MPa] to 0.1 [MPa], for example. The ON/OFF valve 264 may be of a normally closed type. When the ON/OFF valve 264 is controlled to be ON, it opens the flow path and allows the source gas to pass through.

The flow path of the source gas is divided into two systems at a branch point 268 provided after the ON/OFF valve 264, and is connected to the first gas supply passage 248 and the second gas supply passage 250 of the plasma generator 210. The flow restrictor 266 is installed between the branch point 268 and the first gas supply passage 248.

A known flow restrictor may be used as the flow restrictor 266. As the flow restrictor 266, although not shown, a flow restrictor may be used that contains a porous metal body (flow rate control portion) to provide a predetermined piping resistance in the gas flow path.

In this embodiment, the flow restrictor 266 creates a pressure difference between the inflow side and the outflow side. The flow restrictor 266 may reduce the flow rate of the source gas of 0.1 [MPa] to 50 sccm (standard cubic centimeter per minute, 20 °C or 0 °C), for example.

When the ON/OFF valve 264 is turned on, the low-pressure source gas is introduced into the first gas supply passage 248 via the flow restrictor 266. As indicated by arrows A in Fig. 8(a), the source gas introduced into the first gas supply passage 248 flows through the source gas introduction groove 236 of the insulation spacer 216 and the narrowed portion 252 and is introduced into the first chamber 242.

In the first chamber 242, the source gas flows from the back side to the front side of the electrode 214 and then flows into the plasma communication port 228. Here, the side corresponding to the turbomolecular pump 100 is referred to as the front side of the electrode 214, while the opposite sides is referred to as the back side of the electrode 214. The pressure of the source gas acts on the front and back plate surfaces of the electrode 214.

At the same time, the source gas that has not passed through the flow restrictor 266 (the source gas whose flow rate is not restricted) is introduced into the second gas supply passage 250. The source gas introduced into the second gas supply passage 250 is hereinafter referred to as "piston driving gas".

Since the piston driving gas does not pass through the flow restrictor 266, it has a higher pressure than the source gas introduced into the first gas supply passage 248 via the flow restrictor 266. The second gas supply passage 250 is connected to the second chamber 244, and the piston driving gas is introduced into the second chamber 244 as indicated by arrows B in Fig. 8(a).

The head portion 220a of the piston 220 faces the second chamber 244. Thus, the piston driving gas acts on one plate surface (the plate surface facing toward the turbomolecular pump 100) 220b of the head portion 220a, and the piston 220 receives a force from the piston driving gas.

The force of the piston driving gas acts on the piston 220 in the direction away from the turbomolecular pump 100. As such, the piston 220 is pushed away from the turbomolecular pump 100, and the movable body 240 retracts linearly to the right in Fig. 8(a).

As shown in Figs. 5(a) and 8(a), when the movable body 240 retracts and the electrode 214 interferes with the insulation spacer 216, the movable body 240 stops. In this manner, the insulation spacer 216 functions as a stopper when the movable body 240 retracts.

When the ON/OFF valve 264 is turned off, the source gas is not supplied through the source gas supply line 258. The piston driving gas is not supplied to the second chamber 244, and the source gas is supplied only to the turbomolecular pump 100. Additionally, the aforementioned auxiliary pump (back pump) exhausts (creates a rough vacuum in) the turbomolecular pump 100. The rough vacuum prevents the process gas or the like from remaining within the turbomolecular pump 100 and causing chemical reactions or corrosion. As a result, the pressures in the first chamber 242 and the second chamber 244 are the same.

In contrast, the third chamber 246 is not sealed from the outside air, and the pressure in the third chamber 246 is equal to the atmospheric pressure. Also, because of the rough vacuum created by the auxiliary pump (back pump), the pressures in the first chamber 242 and the second chamber 244 are lower than the pressure in the third chamber 246 (atmospheric pressure). As a result, as indicated by arrows P in Fig. 8(b), the piston 220 is pushed toward the turbomolecular pump 100, and the movable body 240 thus advances linearly to the left in Fig. 8(b).

As shown in Figs. 5(b) and 8(b), when the movable body 240 advances and the electrode 214 interferes with the outer cylinder 127 of the turbomolecular pump 100, the movable body 240 stops. In this manner, the outer cylinder 127 of the turbomolecular pump 100 functions as a stopper when the movable body 240 advances.

Also, when the electrode 214 interferes with the outer cylinder 127 of the turbomolecular pump 100, the electrode 214 comes into planar contact with the outer cylinder 127. Thus, the electrode 214 seals (closes) the plasma communication port 228, blocking the spatial connection between the turbomolecular pump 100 and the plasma generator 210.

In the vacuum exhaust apparatus 10 thus configured, the ON/OFF valve 264 (Fig. 7) is turned on during cleaning of the turbomolecular pump 100 (in operation mode 2 described above). As shown in Figs. 5(a) and 8(a), the source gas is supplied to the first gas supply passage 248 of the plasma generator 210, while the piston driving gas is supplied to the second gas supply passage 250. As a result, the electrode 214 is retracted and thus spaced apart from the outer cylinder 127 of the turbomolecular pump 100.

A voltage for plasma generation is applied to the electrode 214. The source gas is ionized by the potential difference between the electrode 214 and the outer cylinder 127 and the potential difference between the electrode 214 and the cylinder 212 to generate radical atoms of the source gas.

When the turbomolecular pump 100 is on standby (in operation mode 3 described above), the ON/OFF valve 264 (Fig. 7) is turned off, and no piston driving gas is supplied to the second gas supply passage 250 as shown in Figs. 5(b) and 8(b). The pressure difference between the third chamber 246 and the second chamber 244 advances the electrode 214, thus sealing the plasma communication port 228.

The supply line 258 of the source gas may be included in the plasma generator 210. Also, it may be considered that the supply line 258 and the plasma generator 210 collectively form a "plasma generation system", for example.

### <Advantages of Vacuum Exhaust Apparatus 10>

According to the vacuum exhaust apparatus 10 described above, the electrode 214 provided in the cylinder 212 of the plasma generator 210 can open and close the plasma communication port 228 between the turbomolecular pump 100 and the plasma generator 210. Also, the mechanism for closing and opening the plasma communication port 228 can be integrated in the plasma generator 210. This enables the downsizing of the vacuum exhaust apparatus 10. As a result, the installation location of the vacuum exhaust apparatus 10 with the plasma cleaning function is not restricted due to its size.

The vacuum exhaust apparatus 10 allows the supply of source gas to be turned on and off with the ON/OFF valve 264, allowing the electrode 214 to be displaced with a simple mechanism.

The plasma generator 210 becomes hot when generating plasma. However, since the cylinder 212 is fixed to the outer cylinder 127 of the turbomolecular pump 100 in a manner that enables heat transfer, the heat generated in the plasma generator 210 can be released to the outer cylinder 127 of the turbomolecular pump 100.

Furthermore, the vacuum exhaust apparatus 10 can prevent reaction products from accumulating inside the plasma generator 210. As such, not only the inside of the turbomolecular pump 100 but also the inside of the plasma generator 210 can be maintained clean.

The electrode 214 is separated from the movable shaft 218 by removing the hexagonal nut 230. Thus, the electrode 214 is attachable and detachable, facilitating replacement of the electrode 214.

In this embodiment, the cylinder 212 is grounded. However, the configuration is not limited to this, and the lid 226 may be made of a conductive material, a crimp terminal may be attached to any of the hexagon socket head cap screws 227 fixing the lid 226, and the lid 226 may be grounded.

Also, the plasma generator 210 may be coupled to the turbomolecular pump 100, and the vacuum exhaust apparatus 10 may be sold through distribution channels (sales channels). Alternatively, the plasma generator 210 may be separated from the turbomolecular pump 100, and the plasma generator 210 and the turbomolecular pump 100 may be separately sold through distribution channels. When the turbomolecular pump 100 is moved separately from the plasma generator 210, a lid (not shown) may be attached to the outer cylinder 127 of the turbomolecular pump 100 to close the opening 127b.

Furthermore, as shown in a modification in Fig. 9, the plasma generator 210 may be attached to the turbomolecular pump 100 through a coupling plate 280. In the example of Fig. 9, the coupling plate 280 is fastened together with the cylinder 212 to the seating surface 127a of the outer cylinder 127 with an O-ring 282 interposed between the coupling plate 280 and the outer cylinder 127 of the turbomolecular pump 100.

Arrows G in Fig. 9 indicate that the coupling plate 280 is fixed to the seating surface 127a of the outer cylinder 127 together with the plasma generator 210. The coupling plate 280 may be a part of the plasma generator 210 and included in the plasma generator 210.

The coupling plate 280 has a coupling hole 284 extending in the thickness direction through a central portion of the plate surface. The coupling hole 284 is sized so that the electrode 214 is hidden and the distal end of the movable shaft 218 is exposed. The coupling hole 284 forms the plasma communication port 228 together with the opening 127b of the outer cylinder 127 and the opening 212b of the cylinder 212.

By arranging the coupling plate 280 in this manner, the electrode 214 can be hidden so as not to be exposed. Furthermore, placing the coupling plate 280 eliminates the need for the electrode 214 to directly face the seating surface 127a of the outer cylinder 127, facilitating the processing of the outer cylinder 127.

Specifically, when the coupling plate 280 is not placed, the seating surface 127a of the outer cylinder 127 needs to be sufficiently large and processed to be flat (subjected to planing) to allow the plasma generator 210 to be attached and to maintain a constant distance to the electrode 214. Also, the O-ring 282 needs to be larger than the external dimension of the electrode 214.

In contrast, when the coupling plate 280 is placed, the electrode 214 and the coupling plate 280 face each other, eliminating the need for the seating surface 127a of the outer cylinder 127 to be sized according to the electrode 214. Also, a smaller O-ring may be used as the O-ring 282. Furthermore, it is possible to reduce the range (area) of the seating surface 127a to be flattened. As a result, the area to be subjected to planing can be reduced to the minimum necessary. Moreover, the outer cylinder 127, which is a relatively large-sized component, can be easily processed.

### <Plasma Generator 310 of Second Embodiment>

Fig. 10(a) shows a plasma generator 310 according to a vacuum exhaust apparatus of a second embodiment and its surrounding portion. In the following description of the second embodiment, same reference numerals are given to those that are the same as the first embodiment. The descriptions of such configurations are omitted as appropriate.

The plasma generator 310 according to the second embodiment includes a diaphragm 370, instead of the piston 220 (e.g., Fig. 5(a)) of the first embodiment, to displace the electrode 214. The diaphragm 370 is attached to a cylinder 312 with hexagon socket head cap screws 327 so as to block an opening 312a of the cylinder 312.

Also, the diaphragm 370 is concentrically fixed with a hexagonal nut 338 to the rear end of a movable shaft 318 (the end on the right side in Fig. 10(a), the end on the side opposite to the turbomolecular pump 100). Opposite plate surfaces of the diaphragm 370 face a second chamber 344 and the outside of the plasma generator 310.

In the second embodiment, the ON/OFF valve 264 (Fig. 7) is turned on during cleaning of the turbomolecular pump 100 (in operation mode 2 described above) as in the first embodiment. Then, the source gas is supplied to the first gas supply passage 248 of the plasma generator 310, and the piston driving gas is supplied to the second gas supply passage 250.

The diaphragm 370 is pushed away from the turbomolecular pump 100 by the piston driving gas in the second chamber 344, and the movable body 340 retracts linearly to the right in Fig. 10(a). As a result, the electrode 214 is retracted and thus spaced apart from the outer cylinder 127 of the turbomolecular pump 100 as shown in Fig. 10(a).

When the turbomolecular pump 100 is on standby (in operation mode 3 described above), the ON/OFF valve 264 (Fig. 7) is turned off, and no piston driving gas is supplied to the second gas supply passage 250. Although not shown, the difference between the atmospheric pressure of the outside air and the pressure in the second chamber 344 presses the diaphragm 370 toward the turbomolecular pump 100, deforming the diaphragm 370 into a shape that protrudes toward the turbomolecular pump 100. As a result, the electrode 214 advances and seals the plasma communication port 228.

The second embodiment as described above has the same advantageous effects of the invention as the first embodiment.

### <Plasma Generator 410 of Third Embodiment>

Fig. 10(b) shows a plasma generator 410 according to a vacuum exhaust apparatus of a third embodiment and its surrounding portion. In the following description of the third embodiment, same reference numerals are given to those that are the same as the first embodiment. The descriptions of such configurations are omitted as appropriate.

The plasma generator 410 according to the third embodiment includes a disc-shaped magnet target 420, instead of the piston 220 (e.g., Fig. 5(a)) of the first embodiment, to displace the electrode 214. The magnet target 420 is a magnetic body and is concentrically fixed to the rear end of a movable shaft 418 (the right end in Fig. 10(b), the end opposite to the turbomolecular pump 100) with a hexagonal nut 438.

An opening 412a on one side (right side in Fig. 10(b)) of a cylinder 412 is closed by an electromagnet holding case 426. The electromagnet holding case 426 is attached to the cylinder 412 through hexagon socket head cap screws 427 so as to close the opening 412a of the cylinder 412.

The electromagnet holding case 426 contains an electromagnet 470. The electromagnet 470 may be a single ring or may be formed by combining a plurality of arcuate electromagnets in a ring shape. The electromagnet 470 is disposed adjacent to the electromagnet target. The term "adjacent to" as used herein refers to a position that is close enough to allow a magnetic force to act to displace the electrode 214.

A coil spring 472 is accommodated in a central section inside the electromagnet holding case 426. One end of the coil spring 472 (the right end in Fig. 10(b)) is in contact with the electromagnet holding case 426, and the other end of the coil spring 472 (the left end in Fig. 10(b)) is in contact with the magnet target 420.

The cylinder 412 does not include the second gas supply passage 250, which is provided in the first and second embodiments, and the electrode 214 is displaced using the magnet target 420 and the electromagnet 470.

In the third embodiment, the electromagnet 470 is turned on during cleaning of the turbomolecular pump 100 (in operation mode 2 described above). The magnetic force of the electromagnet 470 acts on the magnet target 420, and the electromagnet 470 attracts the magnet target 420. The coil spring 472 is in a contracted state, and the magnet target 420 interferes with the electromagnet holding case 426. The movable body 440 is at a retracted position as shown in Fig. 10(b), and the electrode 214 is spaced apart from the outer cylinder 127 of the turbomolecular pump 100.

Furthermore, when the turbomolecular pump 100 is on standby (in operation mode 3 described above), the electromagnet 470 is turned off, and the magnet target 420 is released from the electromagnet 470. Although not shown, the coil spring 472 is in an expanded state, and the magnet target 420 moves toward the turbomolecular pump 100. As a result, the electrode 214 advances and seals the plasma communication port 228.

The third embodiment as described above has the same advantageous effects of the invention as the first embodiment. In addition, the second gas supply passage 250 is unnecessary, simplifying the supply line 258 of source gas.

### <Invention that can be Extracted from Embodiments>

The following inventions can be extracted from the embodiments described above.
(1) A vacuum exhaust apparatus (such as the vacuum exhaust apparatus 10) including a vacuum pump (such as the turbomolecular pump 100) and a plasma generator (such as the plasma generator 210, 310, 410), wherein
   the plasma generator
   includes a displaceable electrode (such as the electrode 214) and
   is capable of sealing a plasma communication port (such as the plasma communication port 228) by displacing the electrode during non-operation in which plasma is not generated (the plasma cleaning OFF state shown in Fig. 5(b), a state in which a high voltage is not applied to the electrode and source gas for generating plasma is not supplied to the electrode).
(2) The vacuum exhaust apparatus according to (1), wherein supply piping (such as the supply piping 267, 269) for source gas for generating plasma is connected to the plasma generator, and the source gas is used to displace the electrode.
(3) The vacuum exhaust apparatus according to (2), wherein a piston (such as the piston 220) is disposed on the electrode, and a pressure difference acts on the piston to displace the electrode.
(4) The vacuum exhaust apparatus according to (2), wherein a diaphragm (such as the diaphragm 370) is disposed in the plasma generator, and the diaphragm is deformed by a pressure difference occurring at the diaphragm, thereby displacing the electrode.
(5) The vacuum exhaust apparatus according to (1), wherein
   an electromagnet target (such as the magnet target 420) formed of a magnetic body, and
   an electromagnet (such as the electromagnet 470) disposed adjacent to the electromagnet target
   are disposed in the plasma generator, and
   a magnetic force generated between the electromagnet target and the electromagnet acts on the electromagnet to displace the electrode.
(6) The vacuum exhaust apparatus according to any one of (1) to (5), wherein the vacuum pump and the plasma generator are fixed so as to allow heat to be transferred from the plasma generator to the vacuum pump.
(7) The vacuum exhaust apparatus according to any one of (1) to (5), wherein the electrode faces a casing (such as the outer cylinder 127) of the vacuum pump.
(8) A plasma generator (such as the plasma generator 210, 310, 410) including a displaceable electrode (such as the electrode 214) for plasma generation and for sealing a plasma communication port (such as the plasma communication port 228).

### <Others>

The present invention is not limited to the above-described embodiments, and various modifications and combinations of the embodiments can be made without departing from the scope of the invention.
10 Vacuum exhaust apparatus
100 Turbomolecular pump
127 Outer cylinder
210, 310, 410 Plasma generator
212 Cylinder
214 Electrode
216 Insulation spacer
218 Movable shaft
220 Piston
226 Lid
228 Plasma communication port
240, 340, 440 Movable body
248 First gas supply passage
250 Second gas supply passage
267, 269 Supply piping
370 Diaphragm
420 Magnet target
470 Electromagnet

### [DRAWINGS]

[Fig. 1]
   CONTROLLER
[Fig. 2]
   AMPLIFIER CONTROL CIRCUIT
[Fig. 3]
   <CURRENT INCREASE>
   CONTROL CYCLE
   ELECTROMAGNET CURRENT iL
   TRANSISTOR
[Fig. 4]
   <CURRENT DECREASE>
   CONTROL CYCLE
   ELECTROMAGNET CURRENT iL
   TRANSISTOR
[Fig. 7]
   260 GAS TANK
   262 PRESSURE REGULATING VALVE
   264 ON/OFF VALVE
   250 PISTON DRIVING GAS SUPPLY PORT (SECOND GAS SUPPLY PASSAGE)
   266 FLOW RESTRICTOR
   248 SOURCE GAS SUPPLY PORT (FIRST GAS SUPPLY PASSAGE)

## Claims

1. A vacuum exhaust apparatus comprising a vacuum pump and a plasma generator, wherein
the plasma generator includes a displaceable electrode and is capable of sealing a plasma communication port by displacing the electrode during non-operation in which plasma is not generated.

2. The vacuum exhaust apparatus according to claim 1,
wherein supply piping for source gas for generating plasma is connected to the plasma generator, and the source gas is used to displace the electrode.

3. The vacuum exhaust apparatus according to claim 1,
wherein a piston is disposed in the plasma generator, and the piston is moved by a pressure difference acting on the piston, thereby displacing the electrode.

4. The vacuum exhaust apparatus according to claim 1,
wherein a diaphragm is disposed in the plasma generator, and the diaphragm is deformed by a pressure difference occurring at the diaphragm, thereby displacing the electrode.

5. The vacuum exhaust apparatus according to claim 1,
wherein
an electromagnet target formed of a magnetic body, and
an electromagnet disposed adjacent to the electromagnet target
are disposed in the plasma generator, and
a magnetic force generated between the electromagnet target and the electromagnet acts on the electrode to displace the electrode.

6. The vacuum exhaust apparatus according to any one of claims 1 to 5, wherein the vacuum pump and the plasma generator are fixed so as to allow heat to be transferred from the plasma generator to the vacuum pump.

7. The vacuum exhaust apparatus according to any one of claims 1 to 5, wherein the electrode faces a casing of the vacuum pump.

8. A plasma generator comprising a displaceable electrode for plasma generation and for sealing a plasma communication port.
